Europäisches Patentamt

European Patent Office

Office européen des brevets

(19)

(11) Veröffentlichungsnummer : **0 435 018 B1**

(12) # EUROPÄISCHE PATENTSCHRIFT

(45) Veröffentlichungstag der Patentschrift :
**21.06.95 Patentblatt 95/25**

(51) Int. Cl.⁶ : **H03G 3/20**

(21) Anmeldenummer : **90123085.4**

(22) Anmeldetag : **03.12.90**

(54) **Funk-Empfänger.**

(30) Priorität : **23.12.89 DE 3942959**

(43) Veröffentlichungstag der Anmeldung :
**03.07.91 Patentblatt 91/27**

(45) Bekanntmachung des Hinweises auf die
Patenterteilung :
**21.06.95 Patentblatt 95/25**

(84) Benannte Vertragsstaaten :
**DE FR GB IT**

(56) Entgegenhaltungen :
**DE-A- 3 447 282**
**FR-A- 2 569 920**
**US-A- 4 126 828**

(56) Entgegenhaltungen :
**PATENT ABSTRACTS OF JAPAN vol. 9, no.**
**248 (E-347)4.Oktober 1985 & JP-A-60 096 930 (**
**MATSUSHITA ) 30. Mai 1985**
**PATENT ABSTRACTS OF JAPAN vol. 13, no.**
**108 (P-843)15.März 1989 & JP-A-63 285 767 (**
**VICTOR CO. OF JAPAN ) 22. November 1988**

(73) Patentinhaber : **TEMIC TELEFUNKEN**
**microelectronic GmbH**
**Theresienstrasse 2**
**D-74072 Heilbronn (DE)**

(72) Erfinder : **Rinderle, Heinz**
**Goerdelerstrasse 82**
**W-7100 Heilbronn (DE)**

(74) Vertreter : **Maute, Hans-Jürgen, Dipl.-Ing.**
**TEMIC TELEFUNKEN microelectronic GmbH**
**Postfach 35 35**
**D-74025 Heilbronn (DE)**

EP 0 435 018 B1

**Beschreibung**

Die Erfindung betrifft einen Funkempfänger nach dem Heterodyn-Prinzip oder nach dem Homodyn-Prinzip.

Die Empfangsqualität eines Funk-Empfängers wird von einer Reihe von Kriterien bestimmt. Die wichtigsten Kriterien eines Funk-Empfängers sind Grenzempfindlichkeit, Nachbarkanalselektivität und Großsignalverhalten. Das Großsignalverhalten betrifft hauptsächlich die harmonische Mischung, die Intermodulation und das Blockingverhalten.

Harmonische Mischungen entstehen durch die Bildung der Zwischenfrequenz über die Mischung von Harmonischen der Eingangssignale mit den Harmonischen des Oszillatorsignals. Hierzu ist nur ein Signal erforderlich.

Die bedeutendsten Störkomponenten dieser Art entstehen bei folgenden Frequenzen der Störsignale:

$$f_{st} = f_{in} + 1/2f_z;$$
$$f_{st} = f_{in} + 2/3f_z;$$
$$f_{st} = 2(f_{in} + f_z) \pm f_z$$

Dabei sind $f_{in}$ die Empfangsfrequenz, $f_{st}$ die Störfrequenz und $f_z$ die Zwischenfrequenz.

Intermodulations-Störungen sind Mischprodukte aus mindestens zwei Signalen, die bei entsprechender Frequenz-Konstellation in den Nutzempfangskanal hineinfallen. Die bekanntesten, am stärksten auftretenden Intermodulations-Störungen entstehen durch Intermodulation der zweiten und dritten Ordnung unter folgenden Frequenz-Bedingungen:

2. Ordnung: $f_z = |f_{s2} \pm f_{s1}|$; $f_{in} = |f_{s2} - f_{s1}|$
3. Ordnung: $f_{in} = |2_{fs2} - f_{s1}|$;
$f_{in} = |f_{s1} \pm f_{s2} + f_{s3}|$

Dabei sind $f_{s1}$ bis $f_{s3}$ die Störsignalfrequenzen.

Bestimmend für die Störprodukte sind die Nichtlinearitäten in der Vor- und Mischstufe in Verbindung mit dem Grad der HF-Selektion in der Vorstufe.

Das Blockingverhalten beschreibt das Empfangsverhalten des Empfängers für schwache Nutzsignale unter Anwesenheit starker In-Band-Störsignale. Hierbei handelt es sich um den Effekt, bei dem schwache Nutzsignale im Rauschen verschwinden, wenn starke Störsignale im Empfangsband auftreten. Dies ist z.B. der Fall, wenn durch ein starkes In-Band-Signal die Verstärkung heruntergeregelt wird, wie es beispielsweise bei FM-Rundfunkempfängern der Fall ist.

Die Hauptursache der Empfangsprobleme sind somit die Nichtlinearitäten im Front-End. Diese entstehen sowohl in den aktiven als auch in den passiven Bauelementen. So entstehen neben den mehr bekannten Verzerrungen im Vorstufentransistor und dem (meist integrierten) Mischer auch Verzerrungen (verschiedener Art) in den Varactor-Dioden, die für die Abstimmung der HF-Bandpaßfilter angewandt werden.

Grundsätzlich läßt sich die Problematik der Regelkonzeption eines klassischen FM-Rundfunk-Empfängers in folgende Hauptteile gliedern und behandeln:

a) Ort der Verstärkungssteuerung im Signalweg
b) Art und Eigenschaften der die Verstärkung steuernden Bauelemente
c) Ort und Art der Steuersignal-Erzeugung.

Zu a) und b): Alle modernen Konzepte verwenden zur Steuerung der Verstärkung PIN-Dioden. Genau genommen ist es jedoch eine Steuerung der Signalschwächung im Signalweg vor dem Vorstufentransistor (Ort der Signalschwächung).

Zu c): Grundsätzlich hat sich die Breitbandregelung durchgesetzt, die jedoch zum Teil zusätzlich nach verschiedenen Kriterien gesteuert wird.

Der Vorteil der Breitbandregelung liegt darin, daß starke Störsignale abgeschwächt werden, bevor sie z.B. starke Intermodulation verursachen oder die Varactor-Dioden übersteuern. Der Nachteil der Breitbandregelung besteht darin, daß der Empfang schwacher Nutzsignale (Blocking) beeinträchtigt wird. Diesem Nachteil versucht man durch Steuerung der Regeleinsatzschwelle zu begegnen.

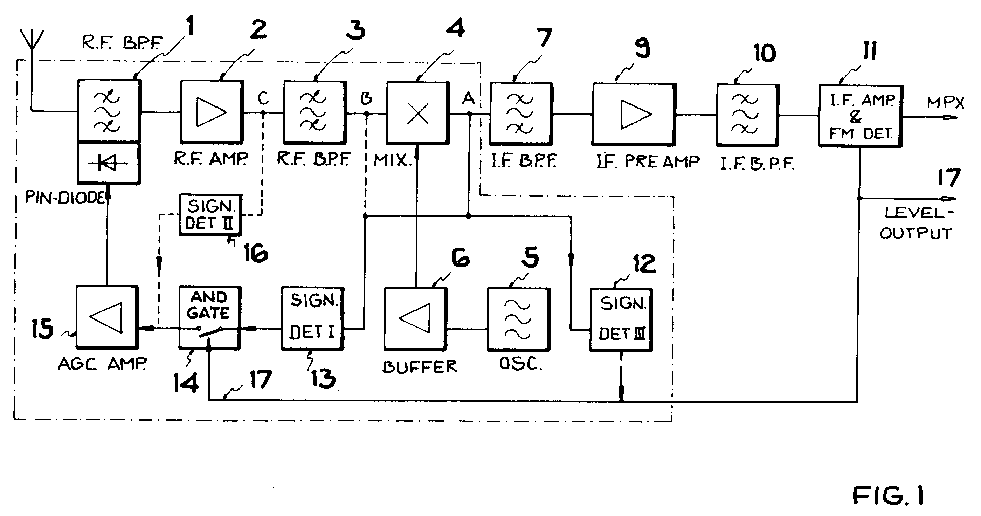

Die Breitbandregelung erfordert, daß die Gewinnung des Regelsignals an entsprechend breitbandigen Punkten im Signalweg vorzunehmen ist. Im allgemeinen sind dies der Mischereingang (Punkt B der Figur 1) oder der Mischerausgang (Punkt A der Figur 1), der entsprechend breitbandig ausgelegt sein muß.

Während die Bandbreite am Mischereingang durch die HF-Bandbreite vorgegeben ist, kann man die Bandbreite am Mischerausgang (ZF-Ebene) und damit die Regelbandbreite zusätzlich beeinflussen. Damit kann eine Einschränkung der Regelbandbreite realisiert werden.

Die Steuerung der Regeleinsatzschwelle entspringt dem Wunsch, einen akzeptablen Kompromiß zwischen der Forderung nach gutem Intermodulationsverhalten einerseits und Vermeidung von starken Blocking-Effekten andererseits zu erreichen.

Zu diesem Zweck wird gemäß der Figur 1, die die Blockschaltung des FM-Teils moderner Autoradios darstellt, die Übertragung des breitbandigen Regelsignals vom Ausgang des ersten Signaldetektors 13 zum Regelsignalverstärker 15 über die "AND GATE"-Schaltung 14 gesteuert. Das Steuersignal ist das Feldstärkesignal des ZF-Verstärkers 11. Bei dieser Form der Regelsignalsteuerung wird erreicht, daß die Breitbandregelung erst wirksam (durchgeschaltet) wird, wenn ein Nutzsignal genügender Stärke vorliegt.

Bei Anwendung einer solchen Regelung tritt allerdings ein Problem auf, wenn der Empfänger auf einen nichtbelegten Nutzkanal eingestellt ist. In diesem Falle würde überhaupt keine Regelung über diesen Weg entstehen, was zur Folge hätte, daß beispielsweise eine unkontrollierte Übersteuerung der Varactor-Dioden auftreten kann.

Um dies zu vermeiden, sind zusätzliche Regelschleifen, bzw. Eingriffsmöglichkeiten vorgesehen. In der Figur 1 sind diese dargestellt. So wird über einen zweiten Signaldetektor 16 ein Regelsignal über Punkt C gewonnen und dieses dem Regelsignalverstärker 15 direkt zugeführt, wodurch das AND-Gate 14 "überbrückt" wird.

Eine andere Möglichkeit bietet die Regelsignalerzeugung über den dritten Signaldetektor 12 (Punkt A) und Einspeisung dessen Ausgangssignals auf die Steuerleitung 17. Bei geeigneter Einstellung der Ansprechschwelle des dritten Signaldetektors 12 kann das AND GATE aktiviert und die Gefahr der Übersteuerung vermieden werden.

Grundsätzlich ließe sich das bei bekannten Funkempfängern auftretende Problem des Blocking-Verhaltens weitgehend lösen, wenn es gelänge, ein Störsignal im Nutzkanal von einem Nutzsignal zu unterscheiden. In diesem Falle wäre ein Entscheidungs-Kriterium verfügbar, das erlaubt, die Regelung nur dann einzuschalten, wenn die Störung den Nutzkanal beeinträchtigt. Dadurch würde vermieden werden, daß der Empfang schwacher Signale, wie nach bisherigem Stand üblich, durch "unnötiges" Herunterregeln der Verstärkung gestört wird (Blocking).

Die Verwirklichung eines Regelkonzepts auf einer solchen Basis würde allerdings eine neuartige Funktionseinheit erfordern, die in der Lage wäre, Interferenzstörungen im Nutzkanal zu erkennen und ein entsprechendes Ausgangssignal zu erzeugen.

Aus der US-A-4 126 828 ist ein Superheterodyn-Empfänger mit einer Schaltung zur Unterdrückung von Interferenzstörungen bekannt. Dieser Empfänger enthält einen in den Signalweg geschalteten Dämpfungsschaltkreis, nämlich zwischen dem Antennenanschluß und dem ersten HF-Verstärker. Im weiteren Signalweg schließt sich ein erster Mischer, ein erster ZF-Verstärker und ein Detektor an. Ferner ist ein weiterer Signalweg vorgesehen, der aus einem zweiten HF-Verstärker, einem zweiten Mischer und einem zweiten ZF-Verstärker aufgebaut ist und direkt von der Antenne gespeist wird. Dieser weitere Signalweg weist eine geringere Linearität auf als der für das Nutzsignal vorgesehene Signalweg. Daher erzeugt der zweite ZF-Verstärker bei Vorliegen einer Interferenzstörung ein stärkeres Ausgangssignal als der erste ZF-Verstärker. Infolgedessen erzeugt eine Vergleichsschaltung, der die gleichgerichteten Signale der beiden ZF-Verstärker zugeführt werden, ein Regelsignal zur Steuerung des Dämpfungsschaltkreises. Dieser bekannte Empfänger weist den Nachteil auf, daß bei gleichzeitigem Empfang mehrerer Störungen, diese nicht immer unterdrückt werden.

Der Erfindung liegt die Aufgabe zugrunde, einen Funkempfänger anzugeben, der Interferenzstörungen weitestgehend unterdrückt. Diese Aufgabe wird durch einen Funkempfänger mit den Merkmalen des Anspruchs 1 gelöst.

Interferenzstörungen sind bekanntlich Störungen, die durch harmonische Mischungen von Störsignalen mit den Harmonischen der Überlagerungsschwingungen des Empfängers, die zur Mischung dienen, entstehen. Zu den Interferenzstörungen zählen auch Intermodulationsstörungen, die durch mindestens zwei Störsignale verursacht werden und die den Nutzkanal stören.

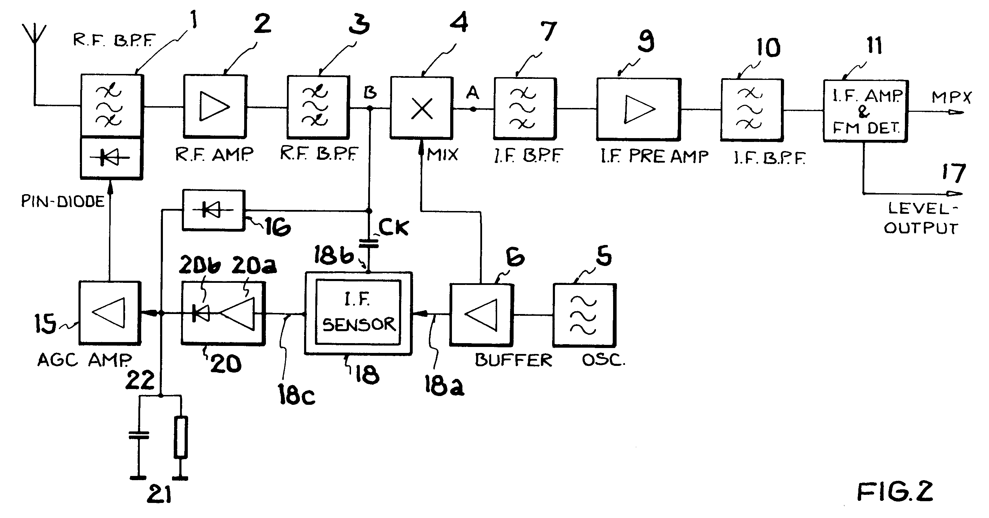

In Figur 2 ist die Grundkonzeption des neuen Regelkonzepts eines FM-Empfangsteils unter Verwendung eines INTERFERENCE-SENSORs nach der Erfindung dargestellt. Die dargestellten klassischen Funktionsbausteine entsprechen denen des Blockschaltbildes nach Figur 1. Der doppelt umrandete Schaltungsteil kennzeichnet die erfindungsgemäße Einrichtung (Interference-Sensor).

Wie die Figur 2 zeigt, ersetzt die Einrichtung nach der Erfindung, die mit der Bezugsziffer 18 bezeichnet ist, die Funktionsbausteine 12, 13 und 14 der Regelkonzeption nach Figur 1. Ferner fehlen gegenüber dem klassischen Regelkonzept die Verknüpfungen mit dem Signalpegel an Punkt A und dem Feldstärke-Ausgangssignal des ZF-Bausteins 11.

Die Funktionsweise ist wie folgt. Der erfindungsgemäßen Einrichtung 18 wird über den Koppelkondensator Ck das zu bewertende Signalgemisch zugeführt. Wegen der Entnahme des Signals vom Mischereingang (Punkt B) umfaßt das Signalgemisch die gleiche HF-Bandbreite, wie sie für den Mischer 4 wirksam ist.

Aus dem vorliegenden Signalgemisch erfaßt die Einrichtung 18 die in den Nutzkanal fallende Interferenzstörung und produziert daraus auf der Ausgangsleitung 18c nur dann ein Gleichsignal, wenn eine Interferenzstörung auftritt.

Das Sensor-Ausgangssignal (18c) wird einer Signalbewertungsschaltung, bestehend aus dem Baustein 20 und der RC-Kombination 21, zugeführt. Diese Schaltung hat die Aufgabe, kurzzeitig auftretende Intermodulationsspitzen mit kurzer Zeitkonstante zu erfassen (Regelargument einzustellen), dagegen bei schnell abfallender Störung das Regelargument mit größerer Zeitkonstante abbauen zu lassen. Damit können Störeffekte, die durch kurzzeitige Pegelschwankungen beider Signalkomponenten, wie sie beispielsweise durch Mehrwegeempfang oder Abschattungen entstehen, wirksam unterdrückt werden.

Im Regelkonzept nach Figur 2 ist ein weiterer Signaldetektor 16 vorgesehen, der die an Punkt B erscheinende Signalamplitude gleichrichtet und das Gleichsignal gleichfalls dem Regelsignalverstärker 15 zuleitet. Damit wird eine zusätzliche Regelschleife gebildet, die der unabhängigen Überwachung der Aussteuerung des Mischers und/oder der Varactor-Dioden am Vorstufenausgang dient und die bei Gefahr der Übersteuerung die Verstärkung herunterregelt.

Normalerweise ist in einem FM Front-End der Empfangsmischer der verzerrungsbestimmende Baustein, weshalb es sinnvoll ist, den Eingang des Mischers mit dem Eingang der Einrichtung 18 zu koppeln. Die Verbindung der Einrichtung 18 mit dem Mischereingang ist auch dann sinnvoll, wenn nicht der Mischer, sondern die Varactor-Dioden des Abstimmkreises am Mischereingang die Interferenzstörungen dominant bilden. Dann ist allerdings zu beachten, daß der Charakter der Nichtlinearität der Einrichtung 18 auf den der Varactor-Dioden angepaßt wird.

Es kann jedoch auch sinnvoll sein, die Interferenzstörung an einem anderen Punkt der Schaltung, z.B. im Bereich der Vorstufe zu "sensen", oder eine zweite Einrichtung nach der Erfindung vorzusehen, die mit einem weiteren kritischen Punkt im Signalweg verbunden wird. Damit wäre es beispielsweise möglich, Interferenzstörungen in der Vorstufe zu erkennen, die bei höherer Selektion bis zum Mischer von der dort angeschalteten Einrichtung nicht erfaßt werden.

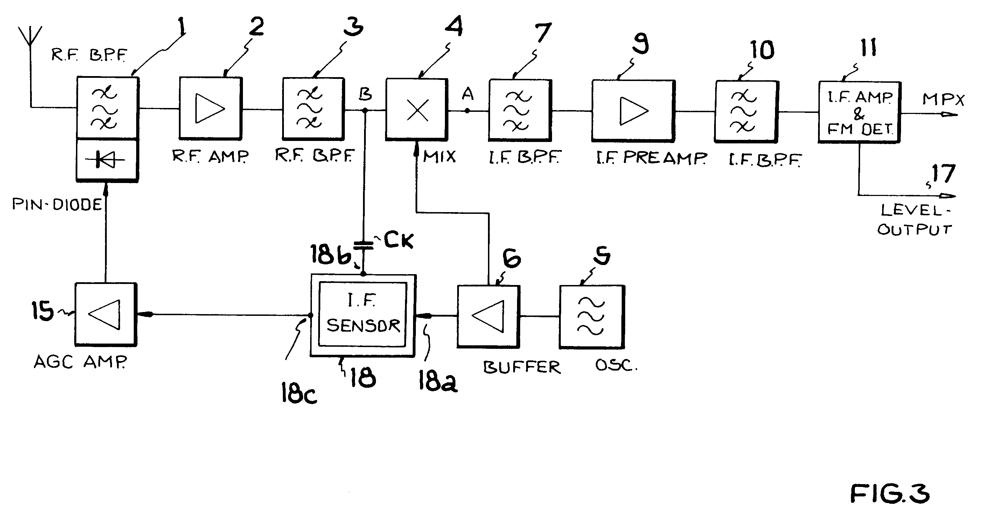

Die Schaltung der Figur 3 unterscheidet sich von der Schaltung der Figur 2 dadurch, daß die Bewertungsschaltung 20 nicht vorhanden ist und das Ausgangssignal der Einrichtung 18 direkt dem AGC-Verstärker 15 zugeführt wird.

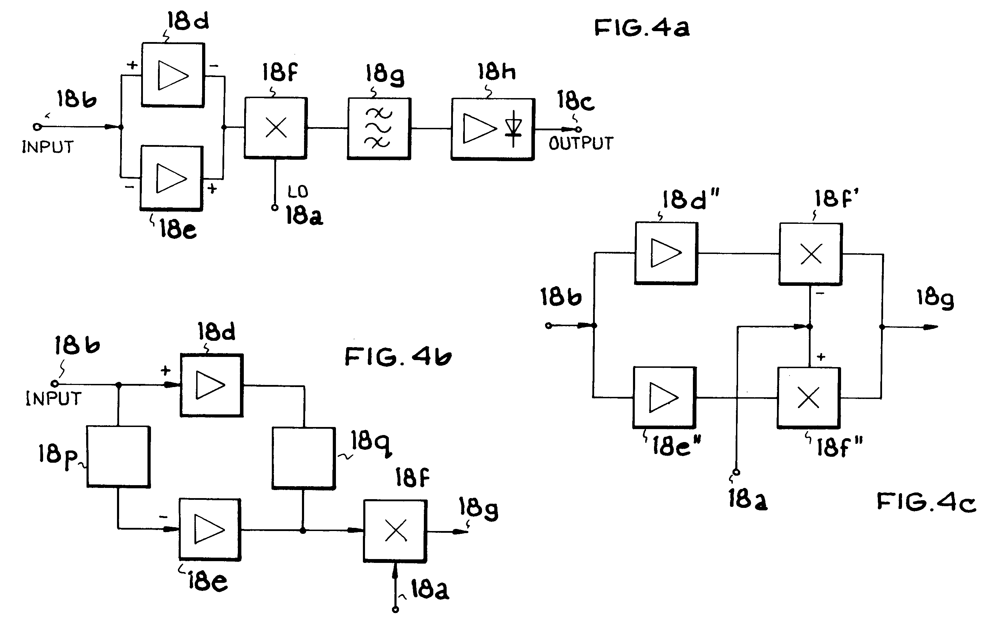

Die Figur 4 zeigt drei Schaltungsprinzipien einer Einrichtung 18 nach der Erfindung, deren Funktionsinhalt dem der doppelt umrandeten Funktionseinheit 18 im Blockschaltbild nach Figur 2 entspricht, einschließlich der Bezugszeichen 18a, 18b und 18c für die Eingangsund Ausgangsklemmen.

Beim Ausführungsbeispiel der Figur 4a wird über die Klemme 18b das zu "sensende" Eingangssignal einem nichtinvertierenden HF-Verstärker 18d und einem invertierenden HF-Verstärker 18e zugeführt. Die Ausgangssignale beider Verstärker werden am Eingang des Mischers 18f zusammengeführt und in diesem mit dem Überlagerungssignal (LO) gemischt. Über das ZF-Bandpaßfilter 18g werden die in das ZF-Band fallenden Signalkomponenten ausgefiltert, in dem Baustein 18h weiterverstärkt und gleichgerichtet. Am Ausgang 18c steht dann das der Kanal-Störung entsprechende Gleichsignal als Regelsignal für die Verstärkung zur Verfügung.

Unter der Voraussetzung, daß die Verstärkungen der beiden HF-Eingangsverstärker 18d und 18e gleich groß bemessen sind, entstehen keine HF-Signalkomponenten am Eingang des Mischers, da sich wegen der Signalinvertierung im Verstärker 18e die Signalkomponenten am Ausgang kompensieren.

Eine Abweichung von diesem Verhalten tritt dann auf, wenn die beiden Verstärker unterschiedliche Charakteristiken hinsichtlich Linearität und Phase aufweisen und gleichzeitig größeren Eingangssignalen ausgesetzt sind. In diesem Falle gibt es Abweichungen in den Verstärker-Ausgangssignalen, die ein entsprechendes Ausgangssignal an der Klemme 18c (Fig. 4a) erzeugen. Die Verstärker 18d und 18e bilden die zusätzlichen Übertragungskanäle nach der Erfindung, während die erfindungsgemäße Einrichtung aus den beiden zusätzlichen Übertragungskanälen (18d, 18e), dem Mischer 18f, dem Filter 18g sowie dem ZF-Verstärker und Demodulator (18h) besteht. Der Demodulator liefert ein Signal, welches der Störung des Nutzkanals entspricht.

Das Prinzip des Sensors bzw. der Einrichtung nach der Erfindung besteht darin, die Nichtlinearitäten der beiden HF-Verstärker (18d, 18e) derartig unterschiedlich zu gestalten, daß die gleichen Interferenz-Störkomponenten wie im Signalweg des Empfängers, jedoch schon bei niedrigeren Störsignalpegeln entstehen.

Da die Nutzsignal-Komponenten nach dem vorliegenden Prinzip kompensiert sind, entstehen am Sensorausgang praktisch nur Signale, die allein durch die Verzerrungen bedingt sind. Ohne diese Kompensation des Nutzsignals würde am Sensorausgang auch durch ein (schwächeres) Nutzsignal ein die Regelung auslösendes Gleichsignal entstehen, was bei der Regelkonzeption nicht erwünscht ist.

Beim Ausführungsbeispiel der Figur 4b sind die beiden HF-Verstärker (18d, 18e) identisch und die unterschiedliche Linearität für beide Zweige wird durch unterschiedlich große Signalamplituden an den Verstärkereingängen bewirkt, z.B. durch Dämpfung der Signalamplitude vom Sensoreingang zum Eingang des Verstärkers 18e'. Um bezogen auf den Mischereingang die Gleichheit der Verstärkung beider Zweige wieder herzustellen, ist am Ausgang des Verstärkers 18d ein entsprechendes signalschwächendes Netzwerk vorgesehen. Dieses besteht im Ausführungsbeispiel der Figur 4b aus den Schaltungsteilen 18p und 18q. Der Schaltungsteil 18p ist zwischen den Eingang (18b) des Verstärkers 18d und zwischen den Eingang des Verstärkers 18e geschaltet. Der Schaltungsteil 18q ist zwischen den Ausgang des Verstärkers 18d und den Ausgang des Verstärkers 18e geschaltet. Die Schaltungsteile 18p und 18q bestehen beispielsweise jeweils aus einem Widerstandsnetzwerk.

Der Vorteil einer Anordnung nach Figur 4b besteht darin, daß die beiden Verstärker (18d, 18e) identisch aufgebaut sein können und daß die Genauigkeit der Kompensation im wesentlichen nur von den (integrierten) Dämpfungsnetzwerken (18p, 18q) abhängig ist.

Beim Ausführungsbeispiel der Figur 4c werden die beiden Signalkomponenten erst am Eingang des ZF-Bandpasses 18g zusammengeführt. Dazu werden die (gleichsinnig gerichteten) Ausgangssignale der beiden HF-Verstärker (18d, 18e) getrennten Mischern 18f' bzw. 18f'' zugeführt. In diesem Falle wird die erforderliche gegensinnige Signaladdition durch gegenphasige Oszillatoransteuerung der Mischer 18f′ bzw. 18f″ bewirkt.

Die notwendige unterschiedliche Nichtlinearität der Zweige können, wie beim Prinzip der Figuren 4a und 4b, im HF-Teil realisiert werden. Möglich sind auch Lösungen, bei denen dies im Mischerteil erfolgt.

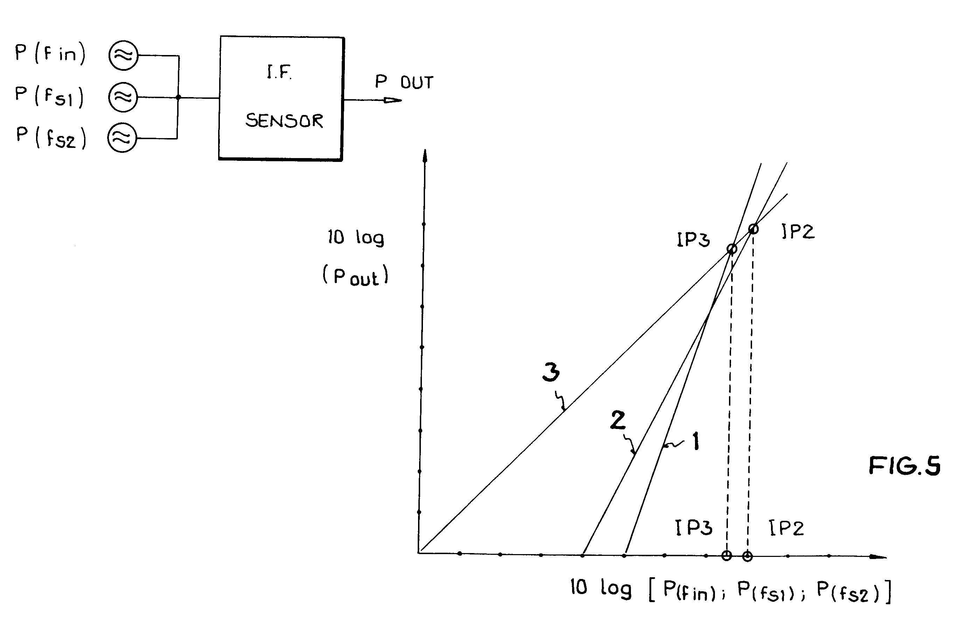

In der Figur 5 ist die (theoretisch) sich ergebende Charakteristik eines nach der Erfindung aufgebauten Interference-Sensors dargestellt. In der doppellogarithmischen Darstellung sind auf der Abszisse die Störsignalpegel (Ps1 und Ps2) am Sensoreingang und auf der Ordinate der DC-Ausgangspegel (Pout) aufgetragen.

Die Kurve 1 charakterisiert beispielsweise das Signalverhalten für Verzerrungen der 3. Ordnung, wenn am Eingang zwei Störsignale gleicher Pegelgröße anliegen, deren Intermodulationsprodukte in den Nutzkanal (fin) fallen.

Die Kurve 2 charakterisiert beispielsweise das Signalverhalten für Verzerrungen der 2. Ordnung, wenn am Eingang zwei Störsignale gleicher Pegelgröße anliegen, deren Intermodulationsprodukte in den Nutzkanal (fin) fallen oder direkt die Zwischenfrequenz (fz) ergeben.

Zum Vergleich zeigt die Kurve 3 den Zusammenhang zwischen dem Ausgangssignal und einem Eingangs-Nutzsignal (gleiche Pegelmaßstäbe der Koordinatenachsen vorausgesetzt), wenn ein Verstärkerzweig (z.B. 18d oder 18e in Figur 4a) nicht vorhanden wäre, also keine Nutzsignalkompensation stattfinden würde.

Danach steigt der Ausgangspegel mit dem Eingangspegel für die Intermodulationsstörungen der 2. Ordnung mit zweifacher Steigung und für die 3. Ordnung mit dreifacher Steigung, verglichen zum linearen Fall (Kurve 3).

Die Kreuzungspunkte IP2 und IP3 der Kurven 2 mit 3, bzw. der Kurven 1 mit 3, sind die sogenannten (theoretischen) Intercept-Points. IP2 charakterisiert das Verhalten für die Intermodulationsverzerrungen der 2. Ordnung und IP3 für die der 3. Ordnung.

In der Figur 5 ist nur die Sensor-Charakteristik für Intermodulationsstörungen der 2. und 3. Ordnung als Beispiel dargestellt. Diese Störungen sind im allgemeinen auch dominant. Grundsätzlich reagiert jedoch solch ein Sensor auf Interferenzstörungen jeglicher Art. Insofern ist ein weitgehender Schutz vor Interferenzstörungen unter Verwendung eines optimierten Sensors denkbar.

Im folgenden werden die wesentlichen Anforderungen genannt, die an einen erfindungsgemäßen Interference-Sensor (Einrichtung) zu stellen sind. Um mit Hilfe des Interference-Sensors alle Interferenzstörungen, die im Zusammenhang mit den Nichtlinearitäten im FM Front-End entstehen, korrekt erkennen zu können, muß der Charakter der Nichtlinearität vom Sensor und von der Funktionsstufe, die die unerwünschten Störungen verursacht, möglichst identisch sein. Darüber hinaus sollte die Bandbreite und die Selektion des ZF-Bandpaßfilters (18g) im Interference-Sensor ähnlich der des ZF-Kanals des Empfängers sein.

Ferner muß die Möglichkeit bestehen, die Empfindlichkeit des Sensors und den Ort des Anschlusses den jeweiligen Bedingungen bzw. Ansprüchen anpassen zu können. Solche Bedingungen sind beispielsweise die Qualität der Störunterdrückung oder die sich ändernde Störempfindlichkeit des Signalweges. Unter einem Signalweg bzw. normalen Übertragungskanal ist der Empfangs-Signalweg eines Empfängers von der Antenne über die Eingangsstufe (1, 2) das Selektionsfilter 3, den Mischer 4 mit dem Oszillator 5 zur Erzeugung des Überlagerungssignals, das Selektionsfilter 7 für die Zwischenfrequenz, den ZF-Vorverstärker 9, ein zweites Selektionsfilter 10 und ein ZF-Verstärker mit Demodulator 11 zu verstehen. Der letztere Fall kann sich ergeben, wenn die Varactor-Dioden das Störverhalten bestimmen. In diesem Falle ändert sich im allgemeinen das Störverhalten mit der Abstimmspannung.

Das Sensor-Ausgangsignal sollte möglichst nur der relevanten Störkomponente entsprechen, d.h., daß die Nutzsignalkomponente im Ausgangssignal unterdrückt sein muß.

Die Sensorschaltung selbst darf im Nutzkanal keine zusätzlichen Störungen verursachen. Dies könnte z.B. dann geschehen, wenn die (gewollte) Nichtlinearität des Sensors über dessen Eingang auf den Empfangsmischer einwirkt.

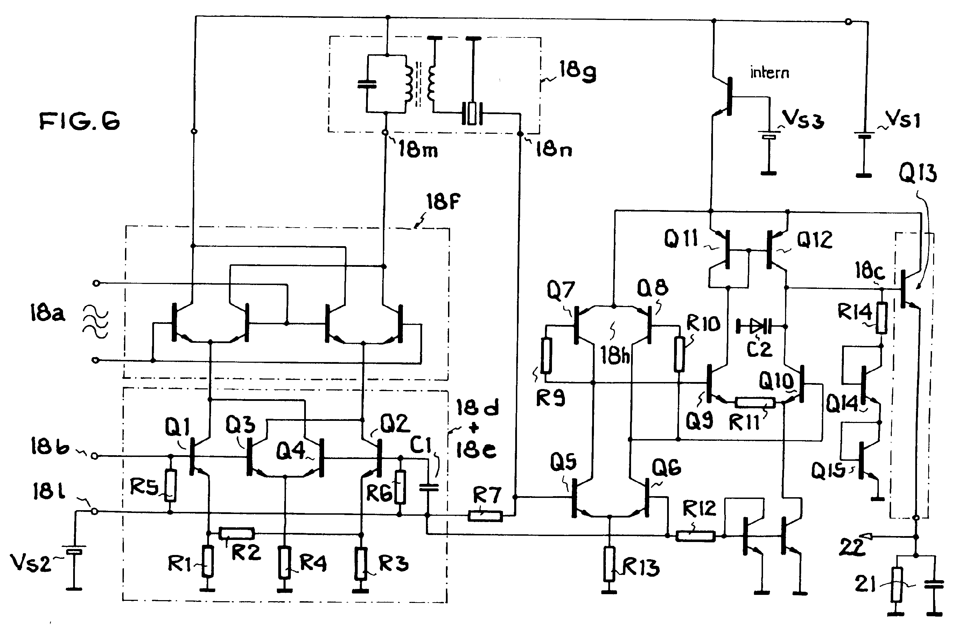

Die Figur 6 zeigt ein Schaltungsbeispiel für einen INTERFERENCE-SENSOR nach dem in der Figur 4a dargestellten Prinzip 1 , einschließlich der Bewertungsschaltung für kurzzeitige Störspitzen. Die HF-Verstärker 18d und 18e sind als Differenzverstärker, bestehend aus den Transistoren Q1 und Q2 (18d) bzw. Q3 und Q4 (18e) ausgeführt.

Der Verstärker 18d besitzt ein Gegenkopplungsnetzwerk im Emitterzweig, bestehend aus den Widerständen R1, R2 und R3, während im Verstärker 18e keine Gegenkopplung verwendet wird. Damit wird die unterschiedliche Linearität der beiden HF-Verstärker erreicht. Die gegensinnige Addition der Ausgangssignale wird durch die entsprechende Vertauschung der Kollektoranschlüsse bewirkt. Der Ausgleich der durch die Gegenkopplung bedingten geringen Steilheit im Verstärker 18d wird durch einen geringeren Betriebsstrom im Verstärker 18e (über R4 bei vorgegebener Spannung Vs2) ausgeglichen.

Dem Mischer 18f werden die Ausgangssignale der HF-Verstärker (18d, 18e) zugeführt, und zwar den Emittern der als Multiplizierer arbeitenden Transistoranordnung, während das Überlagerungssignal über das Klemmenpaar 18a die Basen der Transistoren ansteuert. Das zwischenfrequente Ausgangssignal des Mischers 18f wird (unsymmetrisch) über die Klemme 18m dem ZF-Bandpaßfilter 18g zugeleitet. Am Ausgang 18n dieses Filters steht das relevante Signalgemisch zur Verfügung, das im nachfolgenden Schaltungsteil 18h weiterverstärkt und anschließend gleichgerichtet wird.

Die Signalverstärkung in diesem Schaltungsteil erfolgt in der Differenzverstärkerstufe mit den Transistoren Q5, Q6, Q7 und Q8. Die Signalgleichrichtung wird durch die Schaltungsanordnung, gebildet aus den Transistoren Q9, Q10, Q11 und Q12 und dem Emitterwiderstand R11, bewirkt. Das gleichgerichtete Signal steht am Schaltungspunkt 18c zur Verfügung. Die Kombination Q14, Q15 und R14 dienen der Einstellung der Gleichrichter-Charakteristik.

Die Signalbewertungsschaltung 20 besteht aus dem Emitterfolger Q13, der in Verbindung mit dem RC-Glied 21 als Spitzenwertgleichrichter für ein spitzenbewertetes Ausgangssignal an der Klemme 22 sorgt.

Diese Schaltungsform des Sensors paßt besonders gut zu einem HF-Verstärkerteil einer Empfangsmischerschaltung, die die gleiche Struktur wie der HF-Verstärker 18d des Sensors aufweist und bei der auch die Basispotentiale der Transistoren in den HF-Verstärkern den Baisispotentialen der Transistoren der HF-Verstärker des Sensors entsprechen.

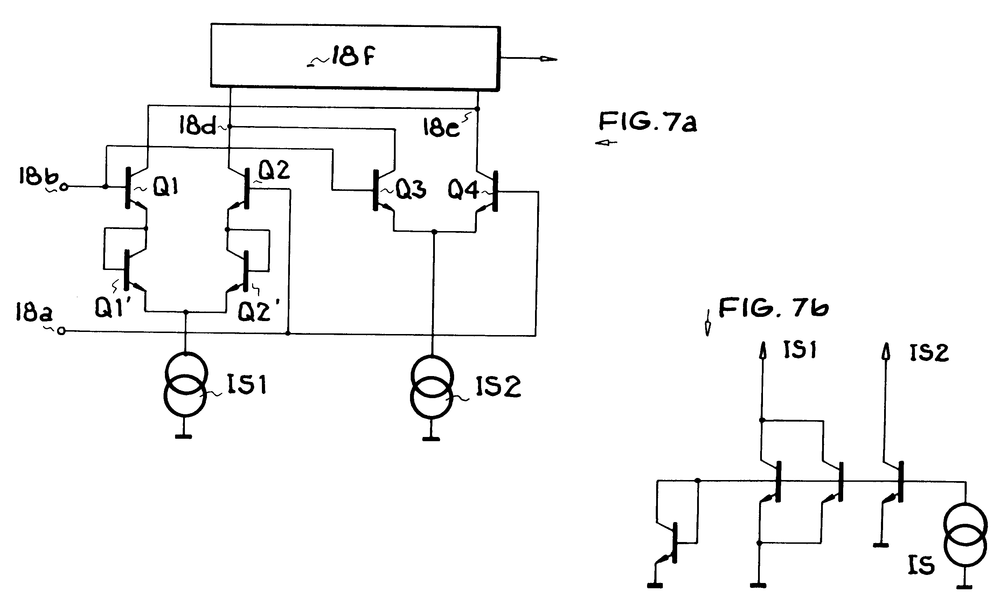

Die Schaltung nach Figur 7a zeigt eine Modifikation des HF-Teils des Sensors. Im Gegensatz zu der in Fig. 6 dargestellten Schaltung, ist im HF-Verstärker 18d kein Widerstandsnetzwerk, sondern ein Transistorpaar Q1'/Q2' zur Gegenkopplung vorgesehen. Der Unterschied der Nichtlinearität beider HF-Verstärker ist definiert. Er entspricht dem Unterschied zweier identischer Differenzverstärker, bei dem einer (18d) mit der halben Amplitude der Störsignale angesteuert wird.

Ebenso gut definiert sind die Steilheiten beider Verstärker. Bei gleich großem Betriebsstrom Is1, bzw. Is2 wäre in der vorliegenden Schaltung die Verstärkung des Verstärkers 18d genau halb so groß wie die des Verstärkers 18e. Um die Nutzsignalkompensation am Ausgang der HF-Verstärker zu erreichen, ist entsprechend den Transistor-Kennliniengesetzen das Verhältnis der Betriebsströme Is2/Is1 = 0.5 zu wählen.

Wegen diesen übersichtlichen Gesetzmäßigkeiten ist diese Schaltungsstruktur für den HF-Verstärkerteil sehr interessant. Ein besonderer Vorteil dieser Schaltung besteht darin, daß bei Erzeugung der Betriebsströme über eine Stromspiegelschaltung, wie in Fig. 7b gezeigt, die Verstärkung (Empfindlichkeit) des Sensors über einen Steuerstrom (Is') eingestellt werden kann ohne dabei die Nutzsignalkompensation und den Charakter der Nichtlinearität beider Verstärker, auch nicht zueinander, zu verändern.

Aufgrund dieser (kontrollierten) Steuerbarkeit ist auf elektronischem Wege das Anpassen an die diversen Bedingungen der Schaltungen leicht möglich.

Die Schaltung nach Figur 7a erzeugt, wegen der symmetrischen Struktur, nur Verzerrungen ungerader Ordnung (3., 5. Ordnung usw.). Damit ist eine kontrollierte Erfassung der wesentlichen Verzerrungen der 2. Ordnung nicht möglich.

Eine Möglichkeit, die Schaltung definiert unsymmetrisch zu gestalten und damit Verzerrungen der 2. Ordnung zu erfassen, besteht darin, die Emitter-Stromdichten in den jeweiligen Zweigen der Differenzverstärker unsymmetrisch auszulegen. Dies kann in einfacher Weise durch unterschiedlich große Emitterflächen der Transistoren nach dem Schema FE(Q1,Q1')>FE(Q2,Q2') und FE(Q4)>FE(Q3) erreicht werden. Dabei kann das Verhältnis der Emitterflächen sowohl größer 1 als auch kleiner 1 sein. Wichtig ist dabei, daß die Zuordnung des Flächenverhältnisses zwischen den beiden Zweigen nach dem obigen Schema erhalten bleibt. Bei falscher Zuordnung heben sich die Verzerrungen 2. Ordnung am Verstärkerausgang auf. Der Grad der Verzerrungen kann durch die Größe des Flächenverhältnisses der Emitterzweige eingestellt werden.

Eine andere Möglichkeit, unterschiedliche Emitterstromdichten einzustellen, besteht in der Vorgabe unterschiedlicher Basispotentiale (18b, 18l). Die Ströme Is1 und Is2 (Fig. 7a) werden beispielsweise gemäß der Figur 7b durch eine Stromspiegelschaltung erzeugt, bei der eine Stromquelle Is den Eingangsstrom für den Stromspiegel liefert. Die Stromspiegelschaltung der Figur 7b liefert die Ausgangsströme Is1 und Is2. Mittels des Stromspiegels der Figur 7b kann die Empfindlichkeit des erfindungsgemäßen Sensors (Einrichtung) gesteuert werden.

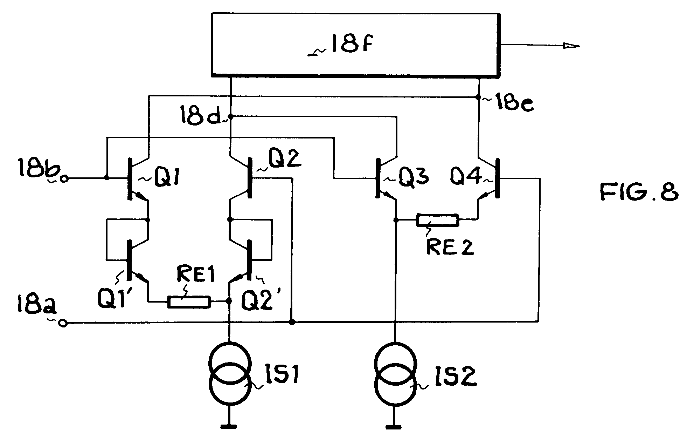

Die Figur 8 zeigt eine 2. Modifikation des HF-Teils eines Sensors, der ebenfalls die Verzerrungen der 2. Ordnung erfassen kann. Zu diesem Zweck sind die Emitterwiderstände RE1 und RE2 vorgesehen, die die Schaltung unsymmetrisch gestalten.

Der Grad der Verzerrungen läßt sich mit der Größe der Widerstandswerte einstellen. Es ist dabei zweckmäßig, die Widerstandswerte so zu wählen, daß der durch diese Widerstände verursachte Gegenkopplungsgrad in beiden Verstärkern (18d, 18e) einander gleich groß ist. Zu beachten ist, daß sich die Verzerrungen der 2. Ordnung nicht am Verstärkerausgang kompensieren sondern sich addieren. Hierzu ist die in der Figur 8 gezeigte Einspeisung der Betriebsströme (Is1, Is2) notwendig.

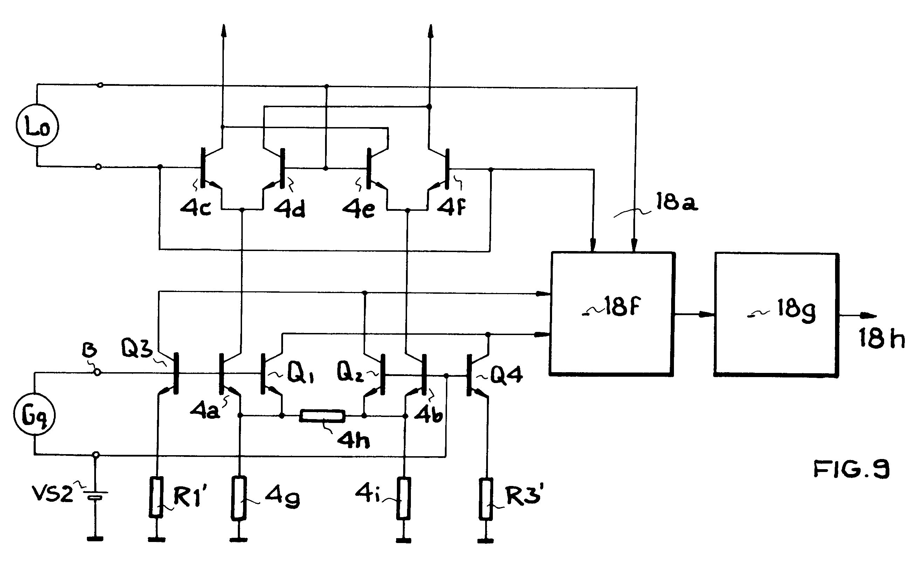

Die Figur 9 zeigt eine Schaltung, bei der die HF-Verstärker des Sensors mit der Schaltung des Empfangsmischers kombiniert sind. Der Empfangsmischer setzt sich hierbei aus den Komponenten 4a bis 4f zusammen, wobei der Hf-Teil des Empfangsmischers durch die Transistoren 4a und 4b und die Widerstände 4g, 4h und 4i, und der Multiplizierer durch die Transistoren 4c, 4d, 4e und 4f gebildet werden. Die Transistoren Q1 und Q2 bilden den ersten HF-Verstärkerzweig des Sensors und die Transistoren Q3 und Q4 den zweiten HF-Verstärkerzweig des Sensors.

Der Sensor-Mischer 18f, der von den Ausgangssignalen der Sensor-HF-Verstärker (Q1 , Q2, Q3 und Q4) angesteuert wird, ist wie bei den vorhergehenden Beispielen vom Empfangsmischer getrennt. Empfangsmischer und Sensor-Mischer werden gemeinsam vom Überlagerungssignal LO angesteuert. Das Eingangssignal, dargestellt durch die Quelle Gq, steuert bei dem vorliegenden Beispiel unsymmetrisch den Eingang des Empfangsmischers und des Sensor-Mischers, und zwar über die Basen der Transistoren 4a, Q1 und Q3. Die Basispotentiale der Transistoren 4a, 4b, Q1, Q2, Q3 und Q4 werden gemeinsam von der Vorspannungsquelle Vs2 festgelegt.

Beim Ausführungsbeispiel der Figur 9 ist die Nichtlinearität des einen Sensor-HF-Verstärkers mit den Transistoren Q1 und Q2 gleich der Nichtlinearität des HF-Verstärkerteils der Empfangsmischerschaltung mit den Transistoren 4a und 4b, während der zweite Sensor-HF-Verstärker mit den Transistoren Q3 und Q4 in Verbindung mit den Widerständen R1' und R2' eine wesentlich geringere Nichtlinearität aufweist. Der Verstärkerzweig mit Q4 und R3' ist bei unsymmetrischer Ansteuerung signaltechnisch nicht wirksam.

Durch die Schaltung der Figur 9 wird erreicht, daß die Nichtlinearität des Sensors praktisch identisch ist mit der Nichtlinearität des Empfangsmischers. Dadurch ist eine hervorragende und reproduzierbare Anpassung des Sensors an den Empfangsmischer erreichbar.

Die Kompensation des Nutzsignals am Ausgang der beiden HF-Verstärker des Sensors wird durch die Wahl geeigneter Flächenverhältnisse der Emitter der Transistoren Q1, 4a, bzw. Q2, 4b sowie von den Widerständen R1', bzw. R3' bestimmt. Dabei ist es zweckmäßig, die Emitterflächen der Transistoren Q1 und Q2 wesentlich kleiner zu wählen als die der Transistoren 4a, bzw. 4b (z.B. 1/20 bis 1/10). Dadurch wird u.a. erreicht, daß der Sensor den Empfangsmischer nur wenig beeinflußt und daß der HF-Teil und Mischer des Sensors, relativ zum Empfangsmischer, wenig Betriebsstrom erfordert. Das Schaltungsbeispiel nach Figur 9 ist für die unsymmetrische Signalansteuerung (Qq) vorgesehen. Sie läßt sich jedoch leicht auch für eine symmetrische Signalansteuerung modifizieren.

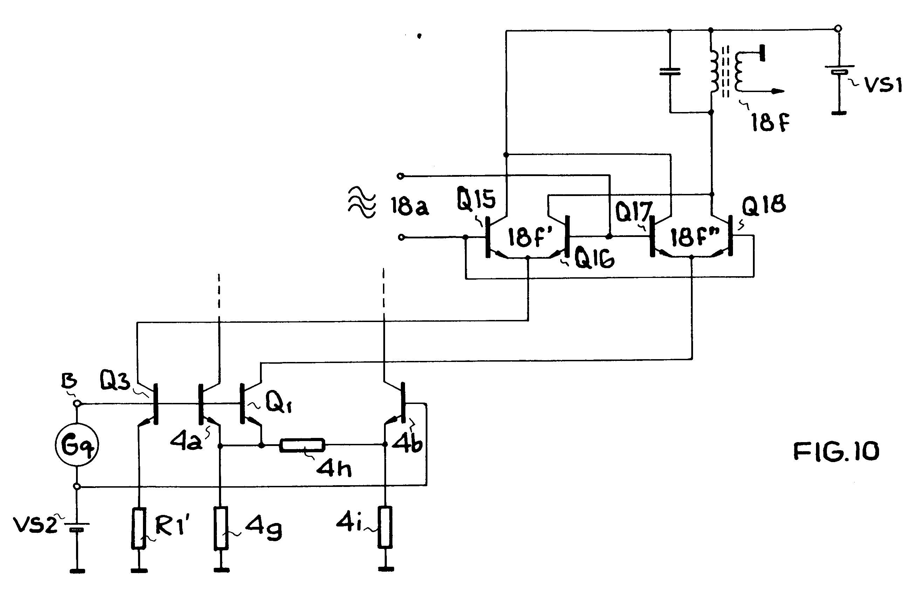

Die Figur 10 zeigt eine vereinfachte Schaltung für die Schaltungskombination von Empfangsmischer und Sensor, die sich aus der Schaltung nach Figur 9 ableiten läßt, wenn ausschließlich nur die unsymmetrische Ansteuerung (Gq) vorgesehen ist. Die Schaltung nach Figur 10 unterscheidet sich u.a. von der der Schaltung nach Figur 9 dadurch, daß die HF-Verstärker des Sensors nur noch aus den Schaltungskomponenten Q1 , Q3 und R1' bestehen. Wegen des Fehlens des HF-Verstärkerzweiges mit dem Transistor Q2 (Figur 9) ist zur Kompensation des Nutzsignals über den Verstärkerzweig mit Q3 und R1' eine entsprechend geringere Verstärkung dieses Zweiges einzustellen. Die Verstärkung dieses Zweiges läßt sich z.B. über den Widerstand R1' einstellen.

Die Ausgangssignale der Sensor-HF-Verstärker werden je einem getrennten Sensor-Mischer 18f' und 18f'', bestehend aus den Transistoren Q15 und Q16 bzw. Q17 und Q18, zugeführt. Während die Ausgangssignale der Sensor-HF-Verstärker den Emitterzweigen der Mischertransistoren zugeführt werden, wird das Überlagerungssignal den Basen dieser Transistoren zugeleitet. Die gegenphasige Addition der Signalkomponenten beider Signalwege erfolgt an den (unsymmetrischen) Ausgängen der beiden Sensor-Mischer, die mit der Selektionseinheit 18g verbunden sind. Damit entspricht die Schaltung nach Figur 10 dem Prinzip 3 nach Figur 4c.

Bei den bisher beschriebenen Beispielen für die Sensorschaltung wurde davon ausgegangen, daß die Nutzsignalkomponente am Sensorausgang unterdrückt (kompensiert) wird, um eine unerwünschte Regelung durch das Nutzsignal zu vermeiden. Unerwünscht ist eine solche Regelung deshalb, weil dadurch das Signal/Rausch-Verhältnis mit zunehmendem Nutzsignalpegel nicht mehr proportional mit dem Nutzsignalpegel ansteigt. Es kann jedoch zweckmäßig sein, die Nutzsignal-Kompensation im Sensor zu vermeiden und statt dessen das Nutzsignal nur bis zu einem bestimmten Maß zu unterdrücken, und zwar nur soweit, daß die Regelung durch ein Nutzsignal einsetzt, wenn für das Nutzsignal ein bestimmtes Signal/Rausch-Verhältnis (z.B. 60 dB) erreicht ist oder spätestens dann einsetzt, wenn ohnehin aus anderen Gründen mit zunehmendem Nutzsignalpegel keine weitere Steigerung des Signal/Rausch-Verhältnisses zu erwarten wäre. Dies ist bei FM-Rundfunkempfang z.B. ab Antennen-Nutzsignalpegel von 0,3 bis 1 mV (an 75 Ohm) der Fall.

Der Vorteil einer so eingestellten begrenzten Nutzsignalunterdrückung in der Sensoreinrichtung und damit der entsprechenden Regeleinsatzschwelle besteht darin, daß Übersteuerungseffekte durch das Nutzsignal (z.B. am Empfangsmischerausgang) vermieden werden.

Das beschriebene Verfahren der Unterdrückung von Interferenzstörungen in Funkempfängern läßt sich nicht nur auf Funkempfänger nach dem klassischen Superhet-Prinzip, bei dem vor der Signaldemodulation das Empfangssignal in ein Zwischenfrequenzsignal umgesetzt wird, sondern auch auf Funkempfänger anwenden, die nach dem Homodyn-Prinzip arbeiten. Bei diesem Empfängerprinzip wird bekanntlich das Empfangssignal direkt in das Basisband umgesetzt, weshalb dieses Empfängerprinzip mehr unter der Bezeichnung "Direktmischende Empfangssysteme", und im angelsächsischen Sprachgebrauch unter den Bezeichnungen "Direct Conversion Concept" oder "Zero IF Concept" bekannt sind.

Bei Anwendung des Verfahrens der Unterdrückung von Interferenzstörungen in Empfängern mit solchen Empfangsprinzipien wird anstelle des ZF-Verstärkers und Demodulators ein Basisbandverstärker mit Tiefpaßverhalten eingesetzt. Ein solcher Basisbandverstärker übernimmt die Selektion des ZF-Verstärkers mit Selektionsverhalten. Der vorgesehene Basisbandverstärker ist ähnlich aufgebaut wie ein Basisbandverstärker im Empfangsteil. Der Sensor-Mischer arbeitet in diesem Falle als Direktmischer, bei dem die Frequenz des Überlagerungssignals gleich der Empfangsfrequenz ist.

**Patentansprüche**

1. Funkempfänger nach dem Heterodyn-Prinzip oder nach dem Homodyn-Prinzip, dadurch gekennzeichnet, daß ein Interference-Sensor (18) vorgesehen ist, dessen Eingang ein Signal zugeführt wird, welches dem Signalweg des Funkempfängers zwischen der Antenne und dem Mischer (4) oder dem Mischereingang (B) entnommen wird, daß der Interference-Sensor zwei zusätzliche zur Störunterdrückung dienende Übertragungskanäle aufweist, daß die beiden zusätzlichen Übertragungskanäle einen unterschiedlichen Verzerrungsgrad aufweisen, daß entweder in den beiden zusätzlichen Übertragungskanälen jeweils eine Mischung mit einem Überlagerungssignal erfolgt und die daraus resultierenden Zwischenfrequenzsignale oder Basisbandsignale gegenphasig zu einem Summensignal addiert werden, oder daß die Ausgangssignale der beiden zusätzlichen Übertragungskanäle gegenphasig zu einem Summensignal addiert werden und das daraus resultierende Summensignal mit einem Überlagerungssignal zu einem Zwischenfrequenzsignal oder Basisbandsignal gemischt wird, daß die nach Addition und Mischung entstehenden, von den Ausgangssignalen der beiden zusätzlichen Übertragungskanäle abgeleiteten Signale frequenzselektiert und demoduliert werden und daß das demodulierte Signal zur Verstärkungsregelung der Eingangsstufe (1) des Empfängers dient.

2. Funkempfänger nach Anspruch 1, dadurch gekennzeichnet, daß der Verzerrungsgrad des einen zusätzlichen Übertragungskanals möglichst gering ist und daß der Verzerrungsgrad des anderen zusätzlichen Übertragungskanals größer ist als der Verzerrungsgrad des normalen Übertragungskanals.

3. Funkempfänger nach Anspruch 1, dadurch gekennzeichnet, daß der Verzerrungsgrad des einen zusätzlichen Übertragungskanals gleich dem Verzerrungsgrad des normalen Übertragungskanals ist und daß der Verzerrungsgrad des anderen zusätzlichen Übertragungskanals kleiner ist als der Verzerrungsgrad des normalen Übertragungskanals.

4. Funkempfänger nach einem der Ansprüche 1 bis 3, dadurch gekennzeichnet, daß das Überlagerungssignal für die Mischung mit den Signalen der zusätzlichen Übertragungskanäle die gleiche Frequenz aufweist wie das Überlagerungssignal für den normalen Übertragungskanal.

5. Funkempfänger nach einem der Ansprüche 1 bis 4, dadurch gekennzeichnet, daß die von Signalen der zusätzlichen Übertragungskanäle abgeleiteten Zwischenfrequenzsignale die gleiche Frequenz wie das Zwischenfrequenzsignal des normalen Übertragungskanals haben.

6. Funkempfänger nach einem der Ansprüche 1 bis 5, dadurch gekennzeichnet, daß die von Signalen der zusätzlichen Übertragungskanäle abgeleiteten Zwischenfrequenzsignale die gleiche Bandbreite wie das Zwischenfrequenzsignal des normalen Empfängerkanals oder eine größere Bandbreite als dieses Zwischenfrequenzsignal haben.

7. Funkempfänger nach einem der Ansprüche 1 bis 6, dadurch gekennzeichnet, daß die Verstärkungsregelung derart erfolgt, daß die Verstärkung reduziert wird, wenn Interferenzstörungen in den Nutzkanal fallen.

8. Funkempfänger nach einem der Ansprüche 1 bis 7, dadurch gekennzeichnet, daß der Interference-Sensor (18) einen oder zwei Mischer (18f, 18f', 18f''), ein Selektionsmittel (18g) und einen Demodulator (18h) aufweist, und daß dessen Ausgangssignal als Regelsignal für die Verstärkungsregelung dient oder vor einer Verstärkungsregelung einer Bewertungsschaltung zugeführt wird.

9. Funkempfänger nach Anspruch 8, dadurch gekennzeichnet, daß der Oszillator (5), der das Überlagerungssignal für den Empfangsmischer (4) liefert, auch das Überlagerungssignal für den oder die Mischer (18f, 18f', 18f'') des Interference-Sensors (18) liefert.

10. Funkempfänger nach einem der Ansprüche 8 oder 9, dadurch gekennzeichnet, daß dem Interference-Sensor (18) eine Bewertungsschaltung (20, 21) nachgeschaltet ist, die die Spitzen des Ausgangssignals des Interference-Sensors (18) stärker bewertet als den Mittelwert des Ausgangssignals des Interference-Sensors (18).

11. Funkempfänger nach Anspruch 10, dadurch gekennzeichnet, daß die Bewertungsschaltung (20, 21) aus einem Spitzenwertgleichrichter besteht.

12. Funkempfänger nach einem der Ansprüche 1 bis 11, dadurch gekennzeichnet, daß die zusätzlichen Übertragungskanäle einen Verstärker (18d, 18e) oder einen Verstärker (18d″, 18e″) plus Mischer (18f′, 18f″) aufweisen.

13. Funkempfänger nach Anspruch 12, dadurch gekennzeichnet, daß die Verstärker (18d, 18e, 18d″, 18e″) einen unterschiedlichen Verzerrungsgrad aufweisen.

14. Funkempfänger nach einem der Ansprüche 12 oder 13, dadurch gekennzeichnet, daß bei Vorhandensein von Verstärkern (18d″, 18e″) plus Mischern (18f′, 18f″) in den zusätzlichen Übertragungskanälen die Verstärker (18d″, 18e″) oder die Verstärker (18d″, 18e″) plus Mischer (18f′, 18f″) oder die Mischer (18f′, 18f″) den unterschiedlichen Verzerrungsgrad ergeben.

15. Funkempfänger nach einem der Ansprüche 12 bis 14, dadurch gekennzeichnet, daß die Verstärkung der Verstärker (18d, 18e, 18d″, 18e″) derart gewählt ist, daß nach der Summierung der beiden Ausgangssignale der beiden zusätzlichen Übertragungskanäle das Nutzsignal zumindest weitgehend kompensiert ist.

16. Funkempfänger nach einem der Ansprüche 1 bis 15, dadurch gekennzeichnet, daß der unterschiedliche Verzerrungsgrad der beiden zusätzlichen Übertragungskanäle durch Verstärker (18d, 18e, 18d″, 18e″) mit gleichem Verzerrungsgrad und unterschiedlich starker Ansteuerung der Verstärker (18d, 18e, 18d″, 18e″) erzielt wird.

17. Funkempfänger nach einem der Ansprüche 1 bis 16, daurch gekennzeichnet, daß die Wirkung des Interference-Sensors (18) steuerbar ist.

18. Funkempfänger nach einem der Ansprüche 1 bis 17, dadurch gekennzeichnet, daß die Verzerrungscharakteristik der Übertragungskanäle des Interference-Sensors (18) der Verzerrungscharakteristik des Empfängerkanals angepaßt ist.

19. Schaltung nach einem der Ansprüche 1 bis 18, dadurch gekennzeichnet, daß der Charakter der Nichtlinearität des Interference-Sensors (18) weitgehend dem des Empfängers entspricht.

20. Schaltung nach einem der Ansprüche 12 bis 19, dadurch gekennzeichnet, daß als Verstärker für die zusätzlichen Übertragungskanäle des Interference-Sensors (18) jeweils ein HF-Verstärker (18d, 18e, 18d″, 18e″) vorgesehen ist, daß die unterschiedliche Nichtlinearität der beiden HF-Verstärker (18d, 18e, 18d″, 18e″) durch unterschiedliche Gegenkopplung in den Emittern der Transistoren (Q1, Q2) der beiden HF-Verstärker (18d, 18e) eingestellt wird.

21. Schaltung nach Anspruch 20, dadurch gekennzeichnet, daß die beiden HF-Verstärker (18d, 18e) des Interference-Sensors (18) als Differenzverstärker ausgebildet sind, daß der erste Differenzverstärker (18e) ohne Gegenkopplung ausgeführt ist und daß der zweite Differenzverstärker (18d) zwei als Dioden geschaltete Transistoren (Q1′, Q2′) als Gegenkopplungselemente im Emitterzweig aufweist.

22. Schaltung nach einem der Ansprüche 1 bis 21, dadurch gekennzeichnet, daß die Empfindlichkeit des Interference-Sensors (18) einstellbar ist.

23. Schaltung nach einem der Ansprüche 20 bis 22, dadurch gekennzeichnet, daß die unterschiedliche Gegenkopplung in den beiden HF-Verstärkern (18d, 18e) des Interference-Sensors (18) durch Widerstände (R1, R2, R3) erfolgt.

24. Schaltung nach einem der Ansprüche 1 bis 23, dadurch gekennzeichnet, daß die Nutzsignalkomponente in dem Interference-Sensor (18) nur soweit unterdrückt wird, daß das Nutzsignal durch den Interference-Sensor (18) ein Regelsignal erzeugt, wenn das Signal/Rauschverhältnis eine vorgegebene Größe erreicht hat oder das Nutzsignal eine vorgegebene Größe erreicht.

25. Schaltung nach einem der Ansprüche 20 bis 24, dadurch gekennzeichnet, daß der HF-Teil (4a, 4b, 4g, 4h, 4i) des Empfangsmischers (4) und die HF-Verstärker (Q1, Q2, Q3, Q4) des Interference-Sensors (18) zu einer Schaltung zusammengefaßt sind.

26. Schaltung nach einem der Ansprüche 20 bis 25, dadurch gekennzeichnet, daß die HF-Verstärker (18d, 18e) des Interference-Sensors (18) derartig unsymmetrisch ausgebildet sind, daß Verzerrungen der zweiten Ordnung von dem Interference-Sensor (18) miterfaßt werden.

27. Schaltung nach einem der Ansprüche 20 bis 26, dadurch gekennzeichnet, daß die Unsymmetrie der HF-Verstärker (18d, 18e) des Interference-Sensors (18) durch unsymmetrische Gegenkopplung in den Zweigen der HF-Verstärker (18d, 18e) eingestellt wird.

## Claims

1. A radio receiver according to the heterodyne principle or the homodyne principle, characterised in that an interference sensor (18) is provided, the input of which is supplied with a signal which is obtained from the signal path of the radio receiver between the antenna and the mixer (4) or from the mixer input (B), that the interference sensor possesses two additional transmission channels which serve for interference suppression, that the two additional transmission channels exhibit a different degree of distortion, that either mixing with a superimposed signal in each case takes place in the two additional transmission channels and the resultant intermediate frequency signals or base band signals are added in phase opposition to form a sum signal, or that the output signals of the two additional transmission channels are added in phase opposition to form a sum signal and the resultant sum signal is mixed with a superimposed signal to form an intermediate frequency signal or base band signal, that the signals which result following the addition and mixing and which are derived from the output signals of the two additional transmission channels are frequency-selected and demodulated, and that the demodulated signal serves for the amplification control of the input stage (1) of the receiver.

2. A radio receiver as claimed in Claim 1, characterised in that the degree of distortion of the first additional transmission channel is as low as possible and that the degree of distortion of the other additional transmission channel is greater than the degree of distortion of the normal transmission channel.

3. A radio receiver as claimed in Claim 1, characterised in that the degree of distortion of the first additional transmission channel is equal to the degree of distortion of the normal transmission channel and that the degree of distortion of the other additional transmission channel is lower than the degree of distortion of the normal transmission channel.

4. A radio receiver as claimed in one of Claims 1 to 3, characterised in that the superimposed signal for the mixing with the signals of the additional transmission channels possesses the same frequency as the superimposed signal for the normal transmission channel.

5. A radio receiver as claimed in one of Claims 1 to 4, characterised in that the intermediate frequency signals derived from signals of the additional transmission channels possess the same frequency as the intermediate frequency signal of the normal transmission channel.

6. A radio receiver as claimed in one of Claims 1 to 5, characterised in that the intermediate frequency signals derived from signals of the additional transmission channels possess the same band width as the intermediate frequency signal of the normal receiver channel or a greater band width than this intermediate frequency signal.

7. A radio receiver as claimed in one of Claims 1 to 6, characterised in that the amplification control takes place in such manner that the amplification is reduced when interference disturbances occur in the basic channel.

8. A radio receiver as claimed in one of Claims 1 to 7, characterised in that the interference sensor (18) comprises one or two mixers (18f, 18f', 18f''), a selection means (18g) and a demodulator (18h), and that its output signal serves as control signal for the amplification control or prior to an amplification control is supplied to a weighting circuit.

9. A radio receiver as claimed in Claim 8, characterised in that the oscillator (5), which supplies the superimposed signal for the receiving mixer (4), also supplies the superimposed signal for the mixer(s) (18f, 18f', 18f'') of the interference sensor (18).

10. A radio receiver as claimed in one of Claims 8 or 9, characterised in that the interference sensor (18) is connected at its output to a weighting circuit (20, 21) which weights the peaks of the output signal of the interference sensor (18) to a greater degree than the mean value of the output signal of the interference sensor (18).

11. A radio receiver as claimed in Claim 10, characterised in that the weighting circuit (20, 21) consists of a peak value rectifier.

12. A radio receiver as claimed in one of Claims 1 to 11, characterised in that the additional transmission channels comprise an amplifier (18d, 18e) or an amplifier (18d'', 18e'') plus mixer (18f', 18f'').

13. A receiver as claimed in Claim 12, characterised in that the amplifiers (18d, 18e, 18d'', 18e'') possess a different degree of distortion.

14. A radio receiver as claimed in one of Claims 12 or 13, characterised in that when amplifiers (18d'', 18e'') plus mixers (18f', 18f'') are present in the additional transmission channels, the amplifiers (18d″, 18e″) or the amplifiers (18d″, 18e″) plus mixers (18f′, 18f″) or the mixers (18f′, 18f″) result in the different degree of distortion.

15. A radio receiver as claimed in one of Claims 12 to 14, characterised in that the amplification of the amplifiers (18d, 18e, 18d″, 18e″) is selected such that following the addition of the two output signals of the two additional transmission channels, the useful signal is at least substantially compensated.

16. A radio receiver as claimed in one of Claims 1 to 15, characterised in that the different degree of distortion of the two additional transmission channels is achieved by means of amplifiers (18d, 18e, 18d″, 18e″) with the same degree of distortion and by the driving of the amplifiers (18d, 18e, 18d″, 18e″) to differing degrees.

17. A radio receiver as claimed in one of Claims 1 to 16, characterised in that the action of the interference sensor (18) is controllable.

18. A radio receiver as claimed in one of Claims 1 to 17, characterised in that the distortion characteristic of the transmission channels of the interference sensor (18) is adapted to the distortion characteristic of the receiver channel.

19. A circuit as claimed in one of Claims 1 to 18, characterised in that the character of the non-linearity of the interference sensor (18) corresponds substantially to that of the receiver.

20. A circuit as claimed in one of Claims 12 to 19, characterised in that a HF amplifier (18d, 18e, 18d″, 18e″) is in each case provided as amplifier for the additional transmission channels of the interference sensor (18), and that the different non-linearity of the two HF amplifiers (18d, 18e, 18d″, 18e″) is set by different negative feedback in the emitters of the transistors (Q1, Q2) of the two HF amplifiers (18d, 18e).

21. A circuit as claimed in Claim 20, characterised in that the two HF amplifiers (18d, 18e) of the interference sensor (18) are designed as differential amplifiers, that the first differential amplifier (18e) is designed without negative feedback, and that the second differential amplifier (18d) comprises two transistors (Q1′, Q2′), connected as diodes, as negative feedback elements in the emitter arm.

22. A circuit as claimed in one of Claims 1 to 21, characterised in that the sensitivity of the interference sensor (18) is adjustable.

23. A circuit as claimed in one of Claims 20 to 22, characterised in that the different negative feedback in the two HF amplifiers (18d, 18e) of the interference sensor (18) is achieved by means of resistors (R1, R2, R3).

24. A circuit as claimed in one of Claims 1 to 23, characterised in that the useful signal component in the interference sensor (18) is suppressed only to the extent that the useful signal through the interference sensor (18) generates a control signal when the signal/noise ratio has reached a predetermined value or the useful signal reaches a predetermined value.

25. A circuit as claimed in one of Claims 20 to 24, characterised in that the HF component (4a, 4b, 4g, 4h, 4i) of the receiving mixer (4) and the HF amplifiers (Q1, Q2, Q3, Q4) of the interference sensor (18) are combined to form a circuit.

26. A circuit as claimed in one of Claims 20 to 25, characterised in that the HF amplifiers (18d, 18e) of the interference sensor (18) are designed to be asymmetrical such that distortions of the second order are additionally detected by the interference sensor (18).

27. A circuit as claimed in one of Claims 20 to 26, characterised in that the asymmetry of the HF amplifiers (18d, 18e) of the interference sensor (18) is set by asymmetrical negative feedback in the arms of the HF amplifiers (18d, 18e).

**Revendications**

1. Récepteur radio selon principe hétérodyne ou selon le principe homodyne, caractérisé en ce qu'un capteur d'interférence (18) est prévu, à l'entrée duquel est amené un signal, lequel est prélevé au trajet de signal du récepteur radio, entre l'antenne et le mélangeur (4) ou à l'entrée de mélangeur (B), que le capteur d'interférence présente deux canaux de transmission supplémentaires servant à la suppression de perturbation, que les deux canaux de transmission supplémentaires présentent un degré de distorsion différent, que, soit, dans les deux canaux de transmission supplémentaires, chaque fois, a lieu un mélange avec un signal de superposition, et les signaux de fréquence intermédiaires ou signaux de bande de base résultant de cela sont additionnés en opposition de phase en un signal de sommation, soit les signaux de sortie des deux canaux de transmission supplémentaires sont additionnés en opposition de phase, en un signal de sommation et le signal de sommation résultant de cela est mélangé avec un signal de superposition en un signal de fréquence intermédiaire ou signal de bande de base, que les signaux, prenant naissance après addition et mélange, dérivés des signaux de sortie des deux canaux de transmission supplémentaires, sont sélectionnés au point de vue fréquence et démodulés, et en ce que le signal démodulé sert pour la régulation d'amplification de l'étage d'entrée (1) du récepteur.

2. Récepteur radio selon la revendication 1, caractérisé en ce que le degré de distorsion de l'un des canaux de transmission supplémentaires est le plus faible possible et en ce que le degré de distorsion de l'autre canal de transmission supplémentaire est plus grand que le degré de distorsion du canal de transmission normal.

3. Récepteur radio selon la revendication 1, caractérisé en ce que le degré de distorsion de l'un des canaux de transmission supplémentaires est identique au degré de distorsion du canal de transmission normal et en ce que le degré de distorsion de l'autre canal de transmission supplémentaire est plus petit que le degré de distorsion du canal de transmission normal.

4. Récepteur radio selon une des revendications 1 à 3, caractérisé en ce que le signal de superposition, pour le mélange avec les signaux des canaux de transmission supplémentaires présente la même fréquence que le canal de superposition pour le canal de transmission normal.

5. Récepteur radio selon une des revendications 1 à 4, caractérisé en ce que les signaux de fréquence intermédiaire, dérivés de signaux des canaux de transmission supplémentaires, ont la même fréquence que le signal de fréquence intermédiaire du canal de transmission normal.

6. Récepteur radio selon une des revendications 1 à 5, caractérisé en ce que les signaux de fréquence intermédiaire, dérivés de signaux des canaux de transmission supplémentaires, ont la même largeur de bande que le signal de fréquence intermédiaire du canal de réception normal ou une largeur de bande plus grande que ce signal de fréquence intermédiaire.

7. Récepteur radio selon une des revendications 1 à 6, caractérisé en ce que la régulation d'amplification a lieu de telle sorte, que l'amplification est réduite lorsque des perturbations d'interférence tombent dans le canal utile.

8. Récepteur radio selon une des revendications 1 à 7, caractérisé en ce que le capteur d'interférence (18) présente un ou deux mélangeurs (18f, 18f', 18''), un moyen de sélection (18g) et un démodulateur (18h), et en ce que le signal de sortie de celui-ci sert comme signal de régulation pour la régulation d'amplification, ou est amené en amont d'une régulation d'amplification d'un circuit d'évaluation.

9. Récepteur radio selon la revendication 8, caractérisé en ce que l'oscillateur (5), qui livre le signal de superposition pour le mélangeur d'entrée (4), livre aussi le signal de superposition pour le ou les mélangeur(s) (18f, 18', 18'') du capteur d'interférence (18).

10. Récepteur radio selon une des revendications 8 ou 9, caractérisé en ce qu'un circuit d'évaluation (20, 21) est mis en circuit en aval du capteur d'interférence (18), qui évalue les pointes du signal de sortie du capteur d'interférence (18) plus fortement que la valeur moyenne du signal de sortie du capteur d'interférence (18).

11. Récepteur radio selon la revendication 10, caractérisé en ce que le circuit d'évaluation (20, 21) est constitué d'un redresseur de valeur de pointe.

12. Récepteur radio selon une des revendications 1 à 11, caractérisé en ce que les canaux de transmission supplémentaires présentent un amplificateur (18d, 18e) ou un amplificateur (18d''; 18e'') plus des mélangeurs (18f', 18f'').

13. Récepteur radio selon la revendication 12, caractérisé en ce que les amplificateurs (18d, 18e, 18d'', 18e'') présentent un degré de distorsion différent.

14. Récepteur radio selon une des revendications 12 ou 13, caractérisé en ce que, lors de présence d'amplificateurs (18d'', 18e'') plus des mélangeurs (18f', 18f''), dans les canaux de transmission supplémentaires, les amplificateurs (18d'', 18e''), ou les amplificateurs (18d'', 18e'') plus des mélangeurs (18f', 18f''), ou les mélangeurs (18f', 18f''), fournissent le degré de distorsion différent.

15. Récepteur radio selon une des revendications 12 à 14, caractérisé en ce que l'amplification des amplificateurs (18d, 18e, 18d'', 18e'') est choisie de telle sorte, qu'après la sommation des deux signaux de sortie des deux canaux de transmission supplémentaires, le signal utile est, au moins dans une large mesure, compensé.

16. Récepteur radio selon une des revendications 1 à 15, caractérisé en ce que le degré de distorsion différent des deux canaux de transmission supplémentaires est atteint grâce à des amplificateurs (18d, 18e, 18d″, 18e″) avec degré de distorsion identique et excitation plus forte différente des amplificateurs (18d, 18e, 18d″, 18e″).

17. Récepteur radio selon une des revendications 1 à 16, caractérisé en ce que l'action du capteur d'interférence (18) est susceptible d'être commandée.

18. Récepteur radio selon une des revendications 1 à 17, caractérisé en ce que la caractéristique de distorsion des canaux de transmission du capteur d'interférence (18) est adaptée à la caractéristique de distorsion du canal de récepteur.

19. Récepteur radio selon une des revendications 1 à 18, caractérisé en ce que le caractère de la non-linéarité du capteur d'interférence (18) correspond dans une large mesure à celui du récepteur.

20. Récepteur radio selon une des revendications 12 à 19, caractérisé en ce que, comme amplificateurs pour les canaux de transmission supplémentaires du capteur d'interférence (18), chaque fois, un amplificateur HF (18d, 18e, 18d″, 18e″) est prévu, que la non-linéarité différente des deux amplificateurs HF (18d, 18e, 18d″, 18e″) est ajustée par contre-réaction différente dans les émetteurs des transistors (Q1, Q2) des deux amplificateurs HF (18d, 18e).

21. Circuit selon la revendication 20, caractérisé en ce que les deux amplificateurs HF (18d, 18e) du capteur d'interférence (18) sont constitués comme des amplificateurs différentiels, que le premier amplificateur différentiel (18e) est exécuté sans contre-réaction, et en ce que le deuxième amplificateur différentiel (18d) présente deux transistors (Q1′, Q2′), mis en circuit comme diodes, comme éléments de contre réaction dans la branche d'émetteur.

22. Récepteur radio selon une des revendications 1 à 21, caractérisé en ce que la sensibilité du capteur d'interférence (18) est susceptible d'être ajustée.

23. Circuit selon une des revendications 20 à 22, caractérisé en ce que la contre réaction différente, dans les deux amplificateurs HF (18d, 18e) du capteur d'interférence (18), a lieu grâce à des résistances (R1, R2, R3).

24. Circuit selon une des revendications 1 à 23, caractérisé en ce que les composantes de signal utile, dans le capteur d'interférence (18), ne sont supprimées que pour autant que le signal utile, grâce au capteur d'interférence (18), engendre un signal de régulation, lorsque le rapport signal-/bruit a atteint une grandeur préallouée ou le signal utile atteint une grandeur préallouée.

25. Circuit selon une des revendications 20 à 24, caractérisé en ce que la partie HF (4a, 4b, 4g, 4h, 4i) du mélangeur de réception (4) et les amplificateurs HF (Q1, Q2, Q3, Q4) du capteur d'interférence (18) sont réunis en un circuit.

26. Circuit selon une des revendications 20 à 25, caractérisé en ce que les amplificateurs HF (18d, 18e) du capteur d'interférence (18) sont constitués de telle sorte asymétriques, que des distorsions du deuxième ordre du capteur d'interférence (18) sont détectées avec ceux-ci.

27. Circuit selon une des revendications 20 à 26, caractérisé en ce que la symétrie des amplificateur HF (18d, 18e) du capteur d'interférence (18) est ajustée par contre-réaction asymétrique dans les branches des amplificateurs HF (18d, 18e).

FIG. 1

FIG.2

R.F. B.P.F. — 1
2
3
4
7
9
10
11

R.F. AMP. — 2
R.F. B.P.F. — 3
B
MIX — 4
A
I.F. B.P.F. — 7
I.F. PRE AMP — 9
I.F. B.P.F. — 10
I.F. AMP. & FM DET. — 11

MPX

PIN-DIODE

CK

18b

16

17

LEVEL-OUTPUT

20b 20a

15

AGC AMP.

20

18c

I.F. SENSOR

18

18a

BUFFER — 6

OSC. — 5

22

21

EP 0 435 018 B1

FIG.3

FIG.4a

FIG.4b

FIG.4c

FIG.5

FIG.6

EP 0 435 018 B1

FIG.7a

FIG.7b

EP 0 435 018 B1

FIG.8

FIG.9

FIG.10